# EUROPEAN PATENT APPLICATION

(11) **EP 4 687 296 A1**
(43) Date of publication of application: **04.02.2026**
(21) Application number: 25190478.5
(22) Date of filing: 18.07.2025
(51) Int. Cl.: H03L 7/08, H03L 7/18

(54) **CIRCUIT AND METHOD FOR ADJUSTING AN OUPUT OF A PHASE LOCKED LOOP TO COMPENSATE FOR A JITTERY INPUT**

(30) Priority: 29.07.2024 US 202463676649 P; 15.07.2025 US 202519269972
(71) Applicant: STMicroelectronics International N.V., 1228 Plan-les-Ouates, Geneva (CH)
(72) Inventor: GUPTA, Sharad, 110059 New Delhi (IN); BAL, Ankur, 201308 Greater Noida (IN)
(74) Representative: Casalonga

(57) **Abstract**

In accordance with various embodiments of the present disclosure, a circuit to adjust a loop division factor (LDF) of a phase locked loop (PLL) is provided. In some embodiments, the circuit comprises processing circuitry configured to (1) determine an amount of jitter of a received input frequency comprising a plurality of input ticks, the amount of jitter being an amount of variation between an expected receipt of each of the plurality of input ticks and an actual receipt thereof, (2) determine a moving average of the determined amount of jitter, (3) determine an adjusted LDF based on the determined moving average of the determined amount of jitter, and (4) output the adjusted LDF to a PLL.

## Description

### CROSS-REFERENCE TO RELATED APPLICATIONS

This application claims priority to and the benefit of US Provisional Patent Application Serial No. 63/676,649, filed July 29, 2024, and titled "CIRCUIT AND METHOD FOR ADJUSTING AN OUPUT OF A PHASE LOCKED LOOP TO COMPENSATE FOR A JITTERY INPUT," which is incorporated herein by reference in its entirety.

### FIELD OF THE INVENTION

Example embodiments of the present disclosure relate generally to phase locked loops and, more particularly, to adjusting a loop division factor of a phase locked loop.

### BACKGROUND

In many systems, such as automotive Ethernet (also termed in-car Ethernet) systems, information is received (input) in packets (e.g., 16-bit or 128-bit packets) and needs to be serialized (i.e., converted to individual bits) to be output serially. The incoming packets of data are typically stored in a random access memory (RAM) buffer. It is important to maintain a correspondence between the packets input to the buffer and the bits output from the buffer, so that the buffer does not overflow.

Along with each packet, a clock tick is sent. These clock ticks, which may be termed F(in), are received at a relatively low frequency, which is a function of the data transmission speed and the packet size (among other factors). The packet size may be selectable but is generally fixed for a given time frame or operation.

A local clock is generated for use in serializing the data, typically using a phase locked loop (PLL). A PLL uses a very accurate oscillator (e.g., a crystal) whose input, F(ref), is multiplied by a loop division factor (LDF) to produce an output, F(out), at the desired frequency.

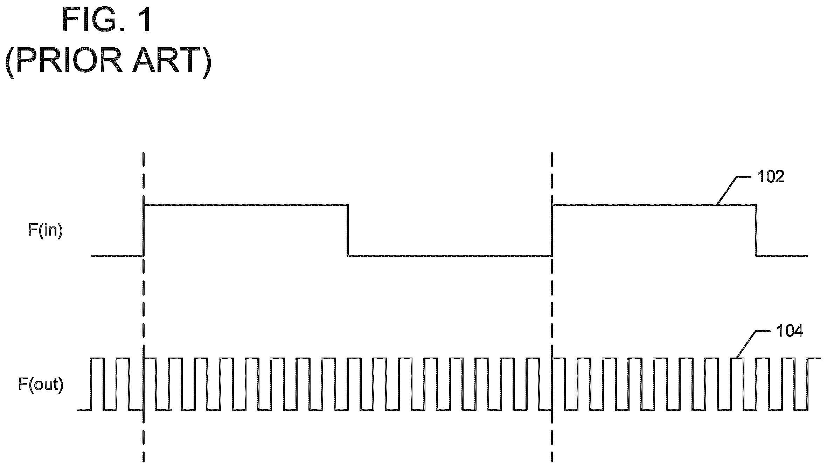

The local clock speed is generally a multiple of the frequency of the packet ticks, which is based on the packet size, and is therefore generally high. For example, if the packets are 16 bits each, the frequency of the local clock signal, F(out), will be 16 times the frequency of the packet ticks (in this example, 16 is the "target multiplier"). That is, there should be 16 local clock ticks for every packet clock tick. FIG. 1 illustrates such an example in which the frequency of the local clock signal 104, F(out), is 16 times the frequency of the packet ticks 102, F(in). The LDF of the PLL is selected such that the PLL provides the desired F(out) (this selected LDF value may be termed "Base LDF").

Because of various factors, such as latency of the incoming data, some of the packets may not come at the expected time. For example, some packets may come sooner than expected (which is a negative delta) and some packets may come later than expected (which is a positive delta). This deviation from the expected timing is called jitter. Jitter can be static, such that each packet has the same delta, or the jitter can be variable, such that the delta can change from packet to packet. Because the local clock frequency is very steady, jitter in the packet tick frequency can negatively affect the correspondence between the packets input to the buffer and the bits output from the buffer and potentially cause the buffer to overflow.

Applicant has identified many technical challenges and difficulties associated with adjusting the output of a PLL to compensate for jitter. Through applied effort, ingenuity, and innovation, Applicant has solved problems related to such technical challenges and difficulties by developing solutions embodied in the present disclosure, which are described in detail below.

### BRIEF SUMMARY

Various embodiments described herein related to circuits and methods for adjusting a loop division factor (LDF) of a phase locked loop (PLL).

In accordance with various embodiments of the present disclosure, a circuit to adjust a loop division factor (LDF) of a phase locked loop (PLL) is provided. In some embodiments, the circuit comprises processing circuitry configured to (1) determine an amount of jitter of a received input frequency comprising a plurality of input ticks, the amount of jitter being an amount of variation between an expected receipt of each of the plurality of input ticks and an actual receipt thereof, (2) determine a moving average of the determined amount of jitter, (3) determine an adjusted LDF based on the determined moving average of the determined amount of jitter, and (4) output the adjusted LDF to a PLL.

In some embodiments, determining an amount of jitter of a received input frequency comprises determining, for each of the plurality of input ticks, a positive delta for each tick that is received later than expected and a negative delta for each tick that is received earlier than expected.

In some embodiments, the moving average is determined over a predetermined number of ticks.

In some embodiments, the adjusted LDF is determined a first time by multiplying an initial LDF by (1 - (the determined moving average divided by a target multiplier of the input frequency).

In some embodiments, the adjusted LDF is determined each subsequent time by multiplying a previously calculated adjusted LDF by (1 - (the determined moving average divided by a target multiplier of the input frequency).

In some embodiments, the processing circuitry is further configured to determine if the amount of jitter of the received input frequency is static or variable.

In some embodiments, the processing circuitry is further configured to update the previously calculated adjusted LDF for use in determining the adjusted LDF at different frequencies depending on whether the amount of jitter of the received input frequency is static or variable.

In some embodiments, the processing circuitry is further configured to update the previously calculated adjusted LDF for use in determining the adjusted LDF less frequently when the jitter is variable than when the jitter is static.

In accordance with various embodiments of the present disclosure, a method of adjusting a loop division factor (LDF) of a phase locked loop (PLL) is provided. In some embodiments, the method comprises receiving an input frequency comprising a plurality of input ticks; determining an amount of jitter of the received input frequency, the amount of jitter being an amount of variation between an expected receipt of each of the plurality of input ticks and an actual receipt thereof; determining a moving average of the determined amount of jitter; determining an adjusted LDF based on the determined moving average of the determined amount of jitter; and outputting the adjusted LDF to a PLL.

The above summary is provided merely for purposes of summarizing some example embodiments to provide a basic understanding of some aspects of the disclosure. Accordingly, it will be appreciated that the above-described embodiments are merely examples and should not be construed to narrow the scope or spirit of the disclosure in any way. It will also be appreciated that the scope of the disclosure encompasses many potential embodiments in addition to those here summarized, some of which will be further described below.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:
FIG. 1 illustrates an example input waveform and output waveform of an example device in which some embodiments of the present disclosure may operate;
FIG. 2 is an example block diagram of an example device in which some embodiments of the present disclosure may operate; and
FIG. 3 is an example flow diagram illustrating an example method of adjusting a loop division factor (LDF) of a phase locked loop (PLL), in accordance with an example embodiment of the present disclosure.

### DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

Various embodiments of the present disclosure overcome the above technical challenges and difficulties and provide various technical improvements and advantages based on, for example, but not limited to, providing example circuits and methods for adjusting an LDF of a PLL to compensate for jitter in an input frequency. In various embodiments, the adjusted LDF provided to a PLL (which may be termed "LDF_OUT") is based on a moving average of the input frequency jitter, target multiplication, and either the base LDF ("BASE_LDF") (for an initial calculation) or a previously adjusted LDF_OUT ("LDF_OUT_LAST") (for subsequent calculations). In various embodiments, LDF_OUT is calculated every tick and provided to the PLL. In various embodiments, the rate at which LDF_OUT_LAST is updated for use in calculating LDF_OUT is based on whether the jitter is static or variable. In various embodiments, the LDF_OUT_LAST update rate is less frequent when the jitter is variable than when the jitter is static.

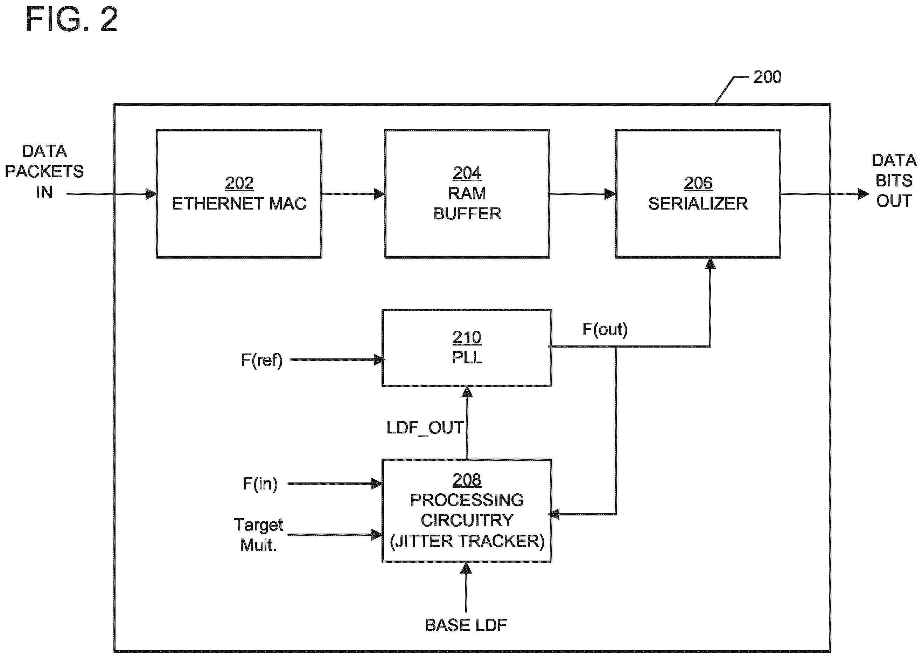

Referring now to FIG. 2, an example block diagram of an example device in which some embodiments of the present disclosure may operate is illustrated. For example, the example device 200 of FIG. 2 may be an automotive Ethernet device, such as an audio speaker interface that receives packets of data (e.g., an audio signal) from a radio receiver via an Ethernet connection (labeled in FIG. 2 as "DATA PACKETS IN"), serializes that received data, and provides the serialized data to an audio speaker (labeled in FIG. 2 as "DATA BITS OUT").

In the illustrated embodiment, the Ethernet data packets are received via an Ethernet medium access control (MAC) 202 and stored in a RAM buffer 204. In the illustrated embodiment, the data packets go from the RAM buffer 204 to a serializer 206 which serializes the data.

The illustrated device 200 comprises a PLL 210 that generates a local clock signal, F(out), for use in serializing the data. As described above, a PLL typically comprises a very accurate oscillator whose input, F(ref), is multiplied by an LDF to produce the output, F(out), at the desired frequency. F(ref) is usually a very stable crystal oscillator which generate a very accurate frequency. Its value is generally kept constant depending upon the spec of the design and will be dependent on the minimum multiplication factor of the F(out) vs F(in). As described above, an LDF is provided to the PLL such that the PLL provides the desired F(out). In various embodiments of the present disclosure, an adjusted LDF ("LDF_OUT") is provided to the PLL 210 to compensate for jitter in the input frequency, as described further below.

The illustrated device 200 comprises processing circuitry, which may also be termed a jitter tracker 208. The jitter tracker 208 receives the packet ticks, F(in), from the Ethernet connection, the output signal, F(out), from the PLL 210, the target multiplier from the specification of packet throughput, and the base LDF from the specification of packet throughput. In various embodiments, the jitter tracker 208 (or any other suitable circuitry) uses the packet ticks, F(in), the output signal, F(out), and the target multiplier to determine if there is jitter in the packet ticks, F(in) (i.e., is there a deviation in the expected timing of the packet ticks, F(in)). In various embodiments, if jitter is present, the jitter tracker 208 uses these same inputs to determine the amount of jitter for each packet tick, which is calculated as a negative delta (if the packet tick comes sooner than expected) or a positive delta (if the packet tick comes later than expected) (some packet ticks may come on time and will have a zero delta). In various embodiments, if jitter is present, the jitter tracker 208 calculates a moving average of the determined amount of jitter. In various embodiments, if jitter is present, the jitter tracker 208 uses the calculated moving average to calculate an adjusted LDF (termed LDF_OUT) that compensates for the jitter. In various embodiments, using a calculated moving average to calculate an adjusted LDF provides a reduction in jitter correction, thereby reducing large LDF swings.

In various embodiments, the calculated LDF_OUT is provided to the PLL every F(in) tick. Rather, in various embodiments, how often LDF_OUT_LAST is updated for use in the LDF_OUT calculation is based on whether the jitter is static or variable. In various embodiments, the jitter tracker 208 determines whether the jitter is static or variable. In various embodiments, the jitter tracker 208 determines whether the jitter is static or variable based on, for example, whether there has been a change to the calculated moving average or to the calculated adjusted LDF_OUT over a predetermined number of previous cycles (e.g., 5 cycles).

Processing circuitry / jitter tracker 208 may be embodied in a number of different ways. In various embodiments, the use of the terms "controller," "controller circuitry," "processor" or "processing circuitry" should be understood to include a single core processor, a multi-core processor, multiple processors internal to the device 200, and/or one or more remote or "cloud" processor(s) external to the device 200. In some example embodiments, the jitter tracker 208 may include one or more processing devices configured to perform independently. Alternatively, or additionally, the jitter tracker 208 may include one or more processor(s) configured in tandem via a bus to enable independent execution of operations, instructions, pipelining, and/or multithreading.

In an example embodiment, the jitter tracker 208 may be configured to execute instructions stored in memory circuitry (not illustrated) or otherwise accessible to the processor. Alternatively, or additionally, the jitter tracker 208 may be configured to execute hard-coded functionality. As such, whether configured by hardware or software methods, or by a combination thereof, the jitter tracker 208 may represent an entity (e.g., physically embodied in circuitry) capable of performing operations according to embodiments of the present disclosure while configured accordingly. Alternatively, or additionally, the jitter tracker 208 may be embodied as an executor of software instructions, and the instructions may specifically configure the jitter tracker 208 to perform the various algorithms embodied in one or more operations described herein when such instructions are executed. In some embodiments, the jitter tracker 208 includes hardware, software, firmware, and/or a combination thereof that performs one or more operations described herein.

Although components are described with respect to functional limitations, it should be understood that the particular implementations necessarily include the use of particular computing hardware. It should also be understood that in some embodiments certain of the components described herein include similar or common hardware. For example, in some embodiments two sets of circuitries both leverage use of the same processor(s), memory(ies), circuitry(ies), and/or the like to perform their associated functions such that duplicate hardware is not required for each set of circuitry.

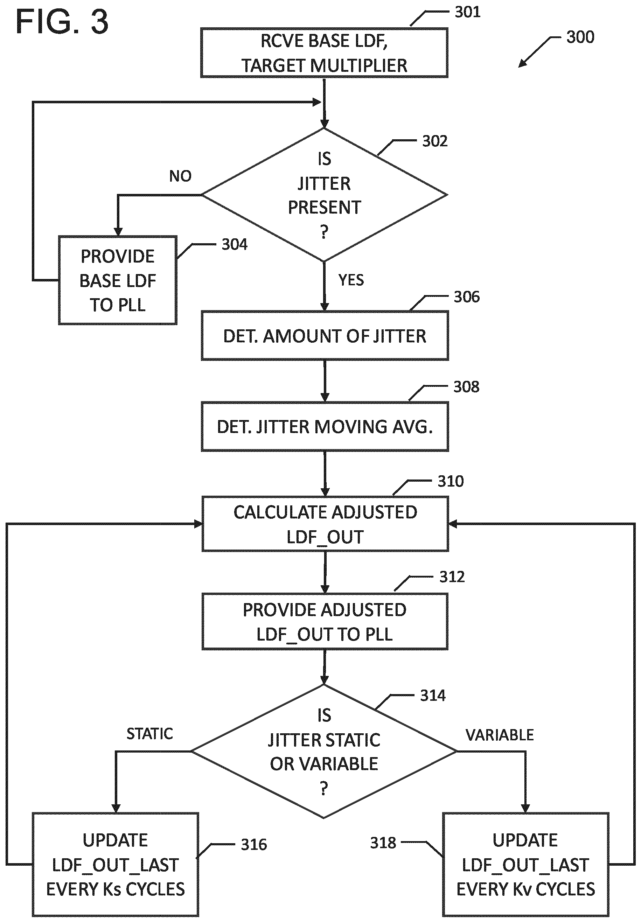

Reference will now be made to FIG. 3, which provides a flowchart illustrating example steps, processes, procedures, and/or operations in accordance with various embodiments of the present disclosure. Various methods described herein, including, for example, example methods as shown in FIG. 3, may provide various technical benefits and improvements. It is noted that each block of the flowchart, and combinations of blocks in the flowchart, may be implemented by various means such as hardware, firmware, circuitry and/or other devices associated with execution of software including one or more computer program instructions. For example, one or more of the procedures described in FIG. 3 may be embodied by computer program instructions, which may be stored by a non-transitory memory of an apparatus employing an embodiment of the present disclosure and executed by a processor in the apparatus. These computer program instructions may direct a computer or other programmable apparatus to function in a particular manner, such that the instructions stored in the computer-readable storage memory produce an article of manufacture, the execution of which implements the function specified in the flowchart block(s).

As described above and as will be appreciated based on this disclosure, embodiments of the present disclosure may be configured as methods, mobile devices, backend network devices, and the like. Accordingly, embodiments may comprise various means including entirely of hardware or any combination of software and hardware. Furthermore, embodiments may take the form of a computer program product on at least one non-transitory computer-readable storage medium having computer-readable program instructions (e.g., computer software) embodied in the storage medium. Similarly, embodiments may take the form of a computer program code stored on at least one non-transitory computer-readable storage medium. Any suitable computer-readable storage medium may be utilized including non-transitory hard disks, CD-ROMs, flash memory, optical storage devices, or magnetic storage devices.

Having described example systems, apparatuses, computing environments, and user interfaces associated with embodiments of the present disclosure, example flowcharts including various operations performed by the circuits, apparatuses, systems, and/or devices described herein will now be discussed. It should be appreciated that each of the flowcharts depicts an example process that may be performed by one or more of the circuits, apparatuses, systems, and/or devices described herein, for example utilizing one or more of the components thereof. The blocks indicating operations of each process may be arranged in any of a number of ways, as depicted and described herein. In some such embodiments, one or more blocks of any of the processes described herein occur concurrently rather than sequentially. In some such embodiments, one or more blocks of any of the processes described herein occur in-between one or more blocks of another process, before one or more blocks of another process, and/or otherwise operates as a subprocess of a second process. Additionally or alternative, any of the processes may include some or all of the steps described and/or depicted, including one or more optional operational blocks in some embodiments. In regard to the below flowcharts, one or more of the depicted blocks may be optional in some, or all, embodiments of the disclosure. Optional blocks are depicted with broken (or "dashed") lines. Similarly, it should be appreciated that one or more of the operations of each flowchart may be combinable, replaceable, re-ordered, and/or otherwise altered as described herein.

Referring now to FIG. 3, an example flow diagram illustrating an example method 300 for adjusting a loop division factor of a phase locked loop in accordance with some embodiments of the present disclosure is illustrated. In some embodiments, the example method 300 may be implemented by an example device described herein, including, but not limited to, the example automotive Ethernet device 200 described above in connection with FIG. 2.

In the example method shown in FIG. 3, the example method 300 starts at step/operation 301. At step/operation 301, a controller (such as, but not limited to, the jitter tracker 208 of the Automotive Ethernet device 200 described above in connection with FIG. 2) receives a base LDF and a target multiplier for a given operation.

At step/operation 302, a controller (such as, but not limited to, the jitter tracker 208 of the Automotive Ethernet device 200 described above in connection with FIG. 2) determines if jitter is present in the input ticks, F(in). As described above, the jitter tracker 208 (or any other suitable circuitry) uses the packet ticks, F(in), the output signal, F(out), and the target multiplier to determine if there is jitter in the packet ticks, F(in). For example, in some embodiments the jitter tracker 208 (or any other suitable circuitry) counts the total number of Fout rising edges in one single Fin tick and compares that against the target multiplier to find the jitter.

If it is determined at step/operation 302 that there is no jitter present in the input ticks, the method 300 proceeds to step/operation 304. At step/operation 304, a controller (such as, but not limited to, the jitter tracker 208 of the Automotive Ethernet device 200 described above in connection with FIG. 2) provides the base LDF (i.e., the unadjusted LDF) to a PLL (such as, but not limited to, the PLL 210 of the Automotive Ethernet device 200 described above in connection with FIG. 2).

If it is determined at step/operation 302 that there is jitter present in the input ticks, the method 300 proceeds to step/operation 306. At step/operation 306, a controller (such as, but not limited to, the jitter tracker 208 of the Automotive Ethernet device 200 described above in connection with FIG. 2) determines an amount of jitter for each packet tick. As described above, the jitter tracker 208 uses the packet ticks, F(in), the output signal, F(out), and the target multiplier to determine the amount of jitter for each packet tick, F(in), which is calculated as a negative delta, a positive delta, or zero delta (for some ticks).

At step/operation 308, a controller (such as, but not limited to, the jitter tracker 208 of the Automotive Ethernet device 200 described above in connection with FIG. 2) determines a moving average of the amount of jitter calculated at step/operation 306. In various embodiments, the jitter tracker 208 calculates the moving average of the amount of jitter based on a predetermined number of most recent calculated deltas. For example, the jitter tracker 208 may calculate the moving average of the amount of jitter based the 32 most recent deltas (however, any suitable number of most recent calculated deltas may be used).

At step/operation 310, a controller (such as, but not limited to, the jitter tracker 208 of the Automotive Ethernet device 200 described above in connection with FIG. 2) uses the moving average calculated at step/operation 308 to calculate an adjusted LDF_OUT. In various embodiments, jitter tracker 208 calculates the adjusted LDF_OUT using the equation: LDF_OUT = (LDF_OUT_LAST or BASE_LDF) x (1 - (moving average / target multiplier)), where LDF_OUT_LAST is a preceding calculated LDF_OUT, moving average is the moving average calculated at step/operation 308, and target multiplier is the predetermined number by which the frequency of the packet ticks is to be multiplied to get the frequency of the local clock. In various embodiments, BASE_LDF is used to calculate the adjusted LDF_OUT initially, and then LDF_OUT_LAST is used for subsequent calculations of the adjusted LDF_OUT.

At step/operation 312, a controller (such as, but not limited to, the jitter tracker 208 of the Automotive Ethernet device 200 described above in connection with FIG. 2) provides the adjusted LDF_OUT to the PLL.

At step/operation 314, a controller (such as, but not limited to, the jitter tracker 208 of the Automotive Ethernet device 200 described above in connection with FIG. 2) determines if the jitter is static or variable. In various embodiments, the jitter tracker 208 determines whether the jitter is static or variable based on, for example, whether there has been a change to the moving average calculated at step/operation 308 or to the adjusted LDF_OUT calculated at step/operation 310 over a predetermined number of previous cycles (e.g., 5 cycles).

If it is determined at step/operation 314 that the jitter is static, the method 300 proceeds to step/operation 316. At step/operation 316, a controller (such as, but not limited to, the jitter tracker 208 of the Automotive Ethernet device 200 described above in connection with FIG. 2) updates the LDF_OUT_LAST value used to calculate the adjusted LDF_OUT with the most recent LDF_OUT calculated at step/operation 310 every Ks cycles (e.g., every 5 cycles). In various embodiments, this updated LDF_OUT_LAST value will be used to calculate the LDF_OUT at step/operation 310 (which is provided to the PLL every tick) until another Ks cycles have occurred and LDF_OUT_LAST is updated again at step/operation 316.

If it is determined at step/operation 314 that the jitter is variable, the method 300 proceeds to step/operation 318. At step/operation 318, a controller (such as, but not limited to, the jitter tracker 208 of the Automotive Ethernet device 200 described above in connection with FIG. 2) updates the LDF_OUT_LAST value used to calculate the adjusted LDF_OUT with the most recent LDF_OUT calculated at step/operation 310 every Kv cycles (e.g., every 32 cycles). In various embodiments, this updated LDF_OUT_LAST will be used to calculate the LDF_OUT at step/operation 310 (which is provided to the PLL every tick) until another Ks cycles have occurred and LDF_OUT_LAST is updated again at step/operation 316.

In various embodiments, the variables Ks and Kv can be any suitable value. In various embodiments, it is generally preferred that Kv > Ks such that LDF_OUT_LAST is updated less frequently when the jitter is variable than when the jitter is static. Updating LDF_OUT_LAST less frequently when the jitter is variable than when the jitter is static helps reduce wide, frequent variations in LDF_OUT.

In some embodiments, the example method shown in FIG. 3 continuously repeats while data is being received.

### Conclusion

Many modifications and other embodiments of the disclosures set forth herein will come to mind to one skilled in the art to which these disclosures pertain having the benefit of teachings presented in the foregoing descriptions and the associated drawings. Although the figures only show certain components of the apparatus and systems described herein, it is understood that various other components may be used in conjunction with the system. Therefore, it is to be understood that the disclosures are not to be limited to the specific embodiments disclosed and that modifications and other embodiments are intended to be included within the scope of the appended claims. Moreover, the steps in the method described above may not necessarily occur in the order depicted in the accompanying diagrams, and in some cases one or more of the steps depicted may occur substantially simultaneously, or additional steps may be involved. Although specific terms are employed herein, they are used in a generic and descriptive sense only and not for purposes of limitation.

While various embodiments in accordance with the principles disclosed herein have been shown and described above, modifications thereof may be made by one skilled in the art without departing from the spirit and the teachings of the disclosure. The embodiments described herein are representative only and are not intended to be limiting. Many variations, combinations, and modifications are possible and are within the scope of the disclosure. Alternative embodiments that result from combining, integrating, and/or omitting features of the embodiment(s) are also within the scope of the disclosure. Accordingly, the scope of protection is not limited by the description set out above.

Additionally, the section headings used herein are provided for consistency with the suggestions under 37 C.F.R. 1.77 or to otherwise provide organizational cues. These headings shall not limit or characterize the disclosure(s) set out in any claims that may issue from this disclosure.

While this detailed description has set forth some embodiments of the present disclosure, the appended claims cover other embodiments of the present disclosure which differ from the described embodiments according to various modifications and improvements. For example, the appended claims can cover any form of device in which the LDF of a PLL needs to be adjusted to account for jitter, such as but not limited automotive audio systems where the data from the automotive Ethernet line is driving multiple speakers in a vehicular multimedia system.

Within the appended claims, unless the specific term "means for" or "step for" is used within a given claim, it is not intended that the claim be interpreted under 35 U.S.C. 112, paragraph 6.

## Claims

1. A circuit to adjust a loop division factor (LDF) of a phase locked loop (PLL), the circuit comprising:
processing circuitry configured to (1) determine an amount of jitter of a received input frequency comprising a plurality of input ticks, the amount of jitter being an amount of variation between an expected receipt of each of the plurality of input ticks and an actual receipt thereof, (2) determine a moving average of the determined amount of jitter, (3) determine an adjusted LDF based on the determined moving average of the determined amount of jitter, and (4) output the adjusted LDF to a PLL.

2. The circuit of claim 1, wherein determining an amount of jitter of a received input frequency comprises determining, for each of the plurality of input ticks, a positive delta for each tick that is received later than expected and a negative delta for each tick that is received earlier than expected.

3. The circuit of claim 1, wherein the moving average is determined over a predetermined number of ticks.

4. The circuit of claim 1, wherein the adjusted LDF is determined a first time by multiplying an initial LDF by (1 - (the determined moving average divided by a target multiplier of the input frequency).

5. The circuit of claim 4, wherein the adjusted LDF is determined each subsequent time by multiplying a previously calculated adjusted LDF by (1 - (the determined moving average divided by a target multiplier of the input frequency).

6. The circuit of claim 5, wherein the processing circuitry is further configured to determine if the amount of jitter of the received input frequency is static or variable.

7. The circuit of claim 6, wherein the processing circuitry is further configured to update the previously calculated adjusted LDF for use in determining the adjusted LDF at different frequencies depending on whether the amount of jitter of the received input frequency is static or variable.

8. The circuit of claim 7, wherein the processing circuitry is further configured to update the previously calculated adjusted LDF for use in determining the adjusted LDF less frequently when the jitter is variable than when the jitter is static.

9. A method of adjusting a loop division factor (LDF) of a phase locked loop (PLL), the method comprising:
receiving an input frequency comprising a plurality of input ticks;
determining an amount of jitter of the received input frequency, the amount of jitter being an amount of variation between an expected receipt of each of the plurality of input ticks and an actual receipt thereof;
determining a moving average of the determined amount of jitter;
determining an adjusted LDF based on the determined moving average of the determined amount of jitter; and
outputting the adjusted LDF to a PLL.

10. The method of claim 9, wherein determining an amount of jitter of a received input frequency comprises determining, for each of the plurality of input ticks, a positive delta for each tick that is received later than expected and a negative delta for each tick that is received earlier than expected.

11. The method of claim 9, wherein the moving average is determined over a predetermined number of ticks.

12. The method of claim 9, wherein the adjusted LDF is determined a first time by multiplying an initial LDF by (1 - (the determined moving average divided by a target multiplier of the input frequency).

13. The method of claim 12, wherein the adjusted LDF is determined each subsequent time by multiplying a previously calculated adjusted LDF by (1 - (the determined moving average divided by a target multiplier of the input frequency).

14. The method of claim 13, further comprising determining if the amount of jitter of the received input frequency is static or variable.

15. The method of claim 14, further comprising:
updating the previously calculated adjusted LDF for use in determining the adjusted LDF at different frequencies depending on whether the amount of jitter of the received input frequency is static or variable.

16. The method of claim 15, further comprising:
updating the previously calculated adjusted LDF for use in determining the adjusted LDF less frequently when the jitter is variable than when the jitter is static.
